# EUROPEAN PATENT APPLICATION

(11) **EP 2 104 409 A2**
(43) Date of publication of application: **23.09.2009**
(21) Application number: 09150574.3
(22) Date of filing: 14.01.2009
(51) Int. Cl.: H05K 7/14

(54) **Precision alignment assembly for rack mount guidance and navigation system**

(30) Priority: 18.03.2008 US 50703
(71) Applicant: Honeywell International Inc., Morristown, NJ 07962 (US)
(72) Inventor: Richason, Chad E., Morristown, NJ 07962-2245 (US); Godfrey, Billy, Morristown, NJ 07962-2245 (US)
(74) Representative: Buckley, Guy Julian

(57) **Abstract**

A system includes a pin assembly (40) having a mating portion (50) of a first axial cross-sectional area, a hilted portion (60) of a second axial cross-sectional area, and a chamfered portion (70) disposed between the mating portion (50) and the hilted portion (60). The chamfered portion (70) has third and fourth axial cross-sectional areas, and axially tapers at a first angle from the third cross-sectional area to the fourth cross-sectional area. A bushing assembly (100) has a mating chamber (110) and receiving port (120) configured to receive the mating portion (50), and a countersink portion (130) circumscribing the receiving port (120). The countersink portion (130) has fifth and sixth axial cross-sectional areas, and axially tapers at a second angle from the fifth cross-sectional area to the sixth cross-sectional area. When the pin assembly (40) and bushing assembly (100) are mated, the countersink portion (130) is configured to constrain radial movement, and movement in at least one axial direction, of the chamfered portion (70).

## Description

### BACKGROUND OF THE INVENTION

Rack mount inertial guidance and navigation (G&N) systems typically have an alignment repeatability requirement imposed on them. A rack mount system allows for convenient installation and removal of G&N systems thus easing maintenance operations and troubleshooting. The challenge with a rack mount system is ensuring alignment repeatability for a given unit or units upon removal and installation. Restraint stability equivalent to a "hardmounted" bolted down system is difficult to attain.

A combination of precision fit daggers 10 and bushings 20 are typically used in rack mount systems, but some "slop" (*i*.*e*., undesired clearance between the dagger and bushing allowing radial movement of the dagger relative to the bushing) remains when the dagger and bushing are mated, as indicated by arrow 30, for fit allowance and machining limitations. This "slop" between the dagger and bushing interface is the main source of uncompensated alignment error in the G&N system.

### SUMMARY OF THE INVENTION

In an embodiment, a system includes a pin assembly having a mating portion of a first axial cross-sectional area, a hilted portion of a second axial cross-sectional area, and a chamfered portion disposed between the mating portion and the hilted portion. The chamfered portion has third and fourth axial cross-sectional areas, and axially tapers at a first angle from the third cross-sectional area to the fourth cross-sectional area. A bushing assembly has a mating chamber and receiving port configured to receive the mating portion, and a countersink portion circumscribing the receiving port. The countersink portion has fifth and sixth axial cross-sectional areas, and axially tapers at a second angle from the fifth cross-sectional area to the sixth cross-sectional area. When the pin assembly and bushing assembly are mated, the countersink portion is configured to constrain radial movement, and movement in at least one axial direction, of the chamfered portion.

### BRIEF DESCRIPTIONS OF THE DRAWINGS

Preferred and alternative embodiments of the present invention are described in detail below with reference to the following drawings:

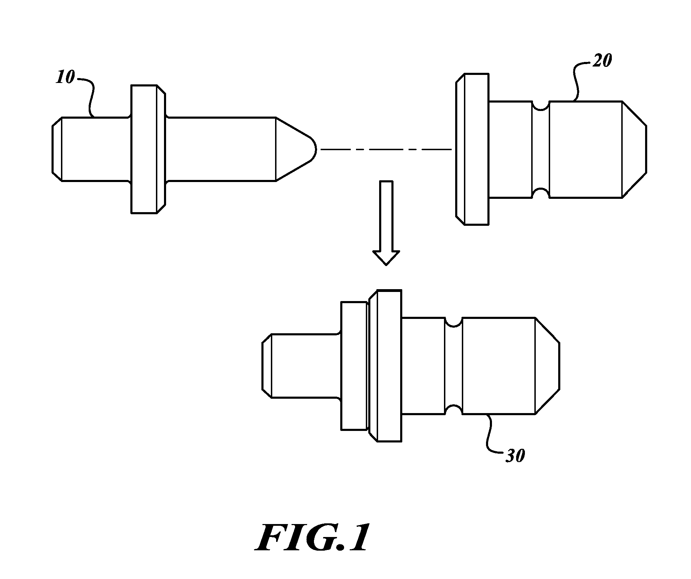

FIGURE 1 is a schematic illustration of a prior art pin-and-bushing arrangement;

FIGURE 2 illustrates a perspective view of a pin assembly according to an embodiment of the present invention;

FIGURE 3 illustrates a perspective view of a bushing assembly according to an embodiment of the present invention;

FIGURE 4 illustrates in partial cross-section mating of the pin and bushing assemblies of FIGS. 2 and 3;

FIGURE 5 illustrates a perspective view of a system according to an embodiment of the invention including an inertial guidance and navigation chassis and a mounting rack;

FIGURE 6 illustrates a perspective view of mounting of the chassis to the mounting rack of FIG. 5; and

FIGURE 7 illustrates a perspective view of the chassis mounted to the rack of FIG. 5.

### DETAILED DESCRIPTION OF THE PREFERRED EMBODIMENT

As will be described more fully hereinafter, A countersink feature added to the bushing which conforms to a specified chamfer on the base of the dagger side will absorb the remaining "slop" between the differences in the diameter of the dagger pin to the diameter of the bushing. The coupling between the countersink feature of the bushing and chamfer on the dagger pin base is essentially a wedge type interface which intimately joins the parts as they are mated together.

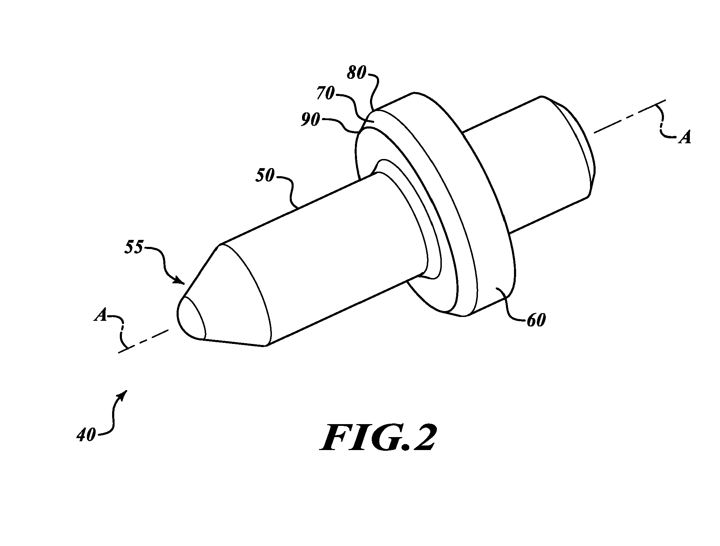

FIG. 2 illustrates a pin assembly 40, according to an embodiment, having a mating portion 50 of a first axial cross-sectional area. The mating portion 50, in an embodiment, may be cylindrical in configuration and may include a conical point 55. The pin assembly 40 further includes a hilted portion 60. As can be seen in FIG. 2, the diameter of the hilted portion 60 is greater than the diameter of the mating portion 50 and, consequently, the cross-sectional area of the hilted portion is greater than the cross-sectional area of the mating portion along an axis A-A. The pin assembly 40 further includes a chamfered portion 70 disposed between the mating portion 50 and the hilted portion 60. The chamfered portion 70 defines a major edge 80 and a minor edge 90. The chamfered portion 70 tapers at an angle along the axis A-A from the major edge 80 to the minor edge 90. The taper angle of the chamfered portion 70 is preferably 45°, but in varying embodiments can be any angle greater than 0° and less than 90°. As such, the diameter of the chamfered portion 70 at the major edge 80 is greater than the diameter of the chamfered portion at the minor edge 90 and, consequently, the cross-sectional area of the chamfered portion at the major edge is greater than the cross-sectional area of the chamfered portion at the minor edge along the axis A-A. The diameter of the major edge 80 may be, but is not necessarily, equal to the diameter of the hilted portion 60.

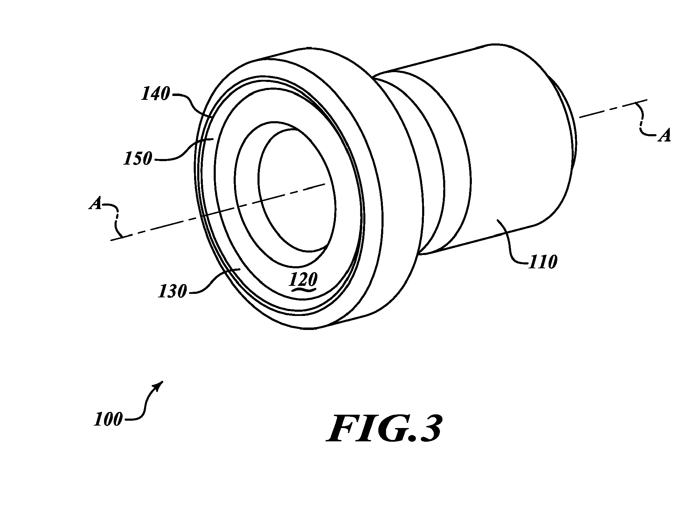

FIG. 3 illustrates a bushing assembly 100, according to an embodiment, having a mating chamber 110 and a receiving port portion 120. The mating chamber 110 is configured to receive the mating portion 50, through the receiving port 120, to enable mating of the pin assembly 40 and bushing assembly 100. The bushing assembly 100 further includes a countersink portion 130 circumscribing the receiving port 120. The countersink portion 130 defines a major edge 140 and a minor edge 150. The countersink portion 130 tapers at an angle along the axis A-A from the major edge 140 to the minor edge 150. The taper angle of the countersink portion 130 is preferably 45°, but in varying embodiments can be any angle greater than 0° and less than 90°, and complementary to the taper angle of the chamfered portion 70. As such, the diameter of the countersink portion 130 at the major edge 140 is greater than the diameter of the countersink portion 130 at the minor edge 150 and, consequently, the cross-sectional area of the countersink portion 130 at the major edge 140 is greater than the cross-sectional area of the countersink portion 130 at the minor edge 150 along the axis A-A.

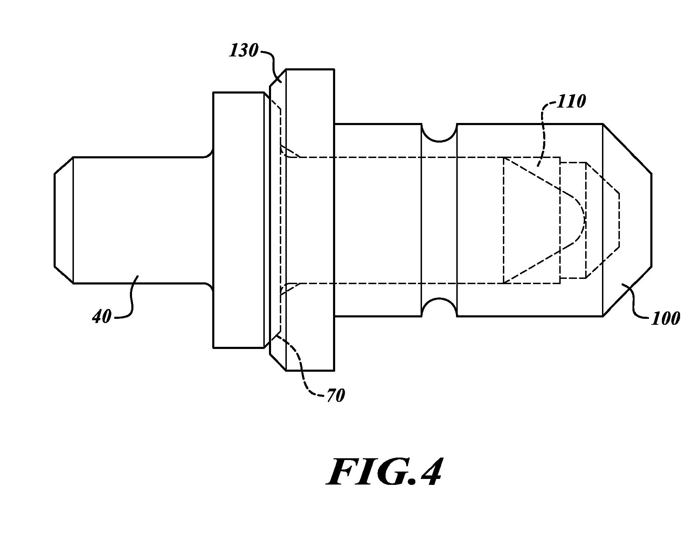

FIG. 4 illustrates, in partial cross-section, the pin assembly 40 mated with the bushing assembly 100. Because the interface between the chamfered portion 70 and countersink portion 130 is wedged, the countersink portion 130 functions to severely limit, if not prevent, radial movement of the pin assembly 40 relative to the bushing assembly 100, as well as axial movement of the pin assembly toward the bushing assembly.

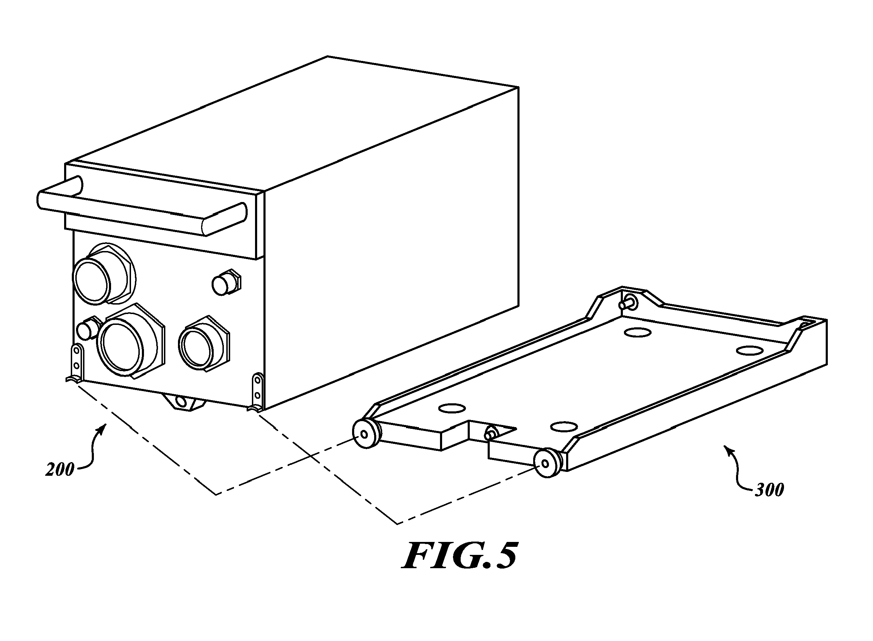

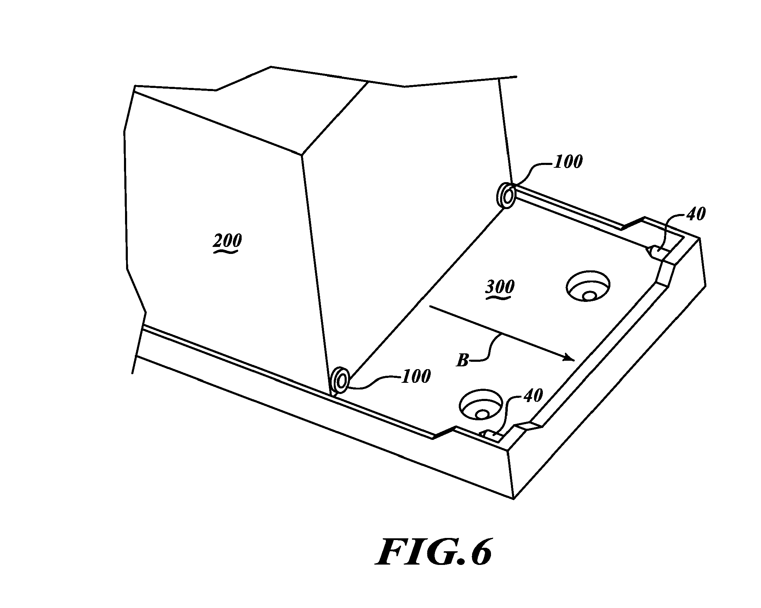

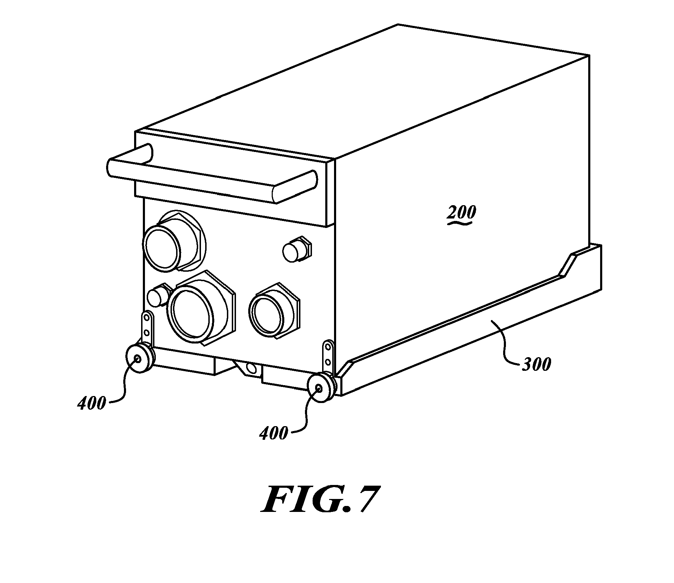

FIG. 5 illustrates a system according to an embodiment of the invention including an inertial guidance and navigation chassis 200 and a mounting rack 300. As best illustrated in FIG. 6, the chassis includes a plurality of bushing assemblies 100, and the rack includes a corresponding plurality of pin assemblies 40. The chassis 200 may be mounted to the rack 300 by sliding the chassis along the rack in the direction of arrow B until the bushing assemblies 100 and pin assemblies 40 are mated. As illustrated in FIG. 7, the rack 300 further includes at least one swingbolt 400 disposed on the side opposite of the rack to that of the pin assemblies 40. The swingbolts 400 are configured to be coupled to the chassis 200, such that, when the chassis is mounted to the rack 300, the swingbolts prevent the chassis from sliding relative to the mount, and constrain axial movement of the bushing assemblies 100 with respect to the pin assemblies 40.

While the preferred embodiment of the invention has been illustrated and described, as noted above, many changes can be made without departing from the spirit and scope of the invention. Accordingly, the scope of the invention is not limited by the disclosure of the preferred embodiment. Instead, the invention should be determined entirely by reference to the claims that follow.
The embodiments of the invention in which an exclusive property or privilege is claimed are defined as follows:

## Claims

1. A system for mounting an inertial guidance and navigation chassis (200) to a rack (300), the system comprising:
a pin assembly (40) having a mating portion (50) of a first axial cross-sectional area, a hilted portion (60) of a second axial cross-sectional area greater than the first cross-sectional area, and a chamfered portion (70) disposed between the mating portion (50) and the hilted portion (60), the chamfered portion (70) having third and fourth axial cross-sectional areas, the chamfered portion (70) axially tapering at a first angle from the third cross-sectional area to the fourth cross-sectional area; and
a bushing assembly (100) having a mating chamber (110) and receiving port (120) configured to receive the mating portion (50) to enable mating of the pin assembly (40) and bushing assembly (100), and a countersink portion (130) circumscribing the receiving port (120), the countersink portion (130) having fifth and sixth axial cross-sectional areas, the countersink portion (130) axially tapering at a second angle from the fifth cross-sectional area to the sixth cross-sectional area;
wherein when the pin assembly (40) and bushing assembly (100) are mated, the countersink portion (130) is configured to constrain radial movement, and movement in at least one axial direction, of the chamfered portion (70).

2. The system of claim 1 wherein the mating portion (50) is cylindrical in configuration.

3. The system of claim 1 wherein the third cross-sectional area is equal to the second cross-sectional area.

4. The system of claim 1 wherein the second angle is complementary to the first angle.

5. The system of claim 1 wherein the pin assembly (40) is configured to be coupled to the rack (300).

6. The system of claim 1 wherein the bushing assembly (100) is configured to be coupled to the chassis (200).

7. A method, comprising the steps of:
forming, from a pin assembly (40), a mating portion (50) of a first axial cross-sectional area, a hilted portion (60) of a second axial cross-sectional area greater than the first cross-sectional area, and a chamfered portion (70) disposed between the mating portion (50) and the hilted portion (60), the chamfered portion (70) having third and fourth axial cross-sectional areas, the chamfered portion (70) axially tapering at a first angle from the third cross-sectional area to the fourth cross-sectional area; and
forming, from a bushing assembly (100), a mating chamber (110) and receiving port (120) configured to receive the mating portion (50) to enable mating of the pin assembly (40) and bushing assembly (100), and a countersink portion (130) circumscribing the receiving port (120), the countersink portion (130) having fifth and sixth axial cross-sectional areas, the countersink portion (130) axially tapering at a second angle from the fifth cross-sectional area to the sixth cross-sectional area;
wherein when the pin assembly (40) and bushing assembly (100) are mated, the countersink portion (130) is configured to constrain radial movement, and movement in at least one axial direction, of the chamfered portion (70).

8. The method of claim 7 wherein the mating portion (50) is cylindrical in configuration.

9. The method of claim 7 wherein the third cross-sectional area is equal to the second cross-sectional area.

10. The method of claim 7 wherein the second angle is complementary to the first angle.
